# EUROPEAN PATENT APPLICATION

(11) **EP 3 421 132 A1**
(43) Date of publication of application: **02.01.2019**
(21) Application number: 18386020.4
(22) Date of filing: 29.06.2018
(51) Int. Cl.: B01L 3/00, B29C 65/48

(54) **MICROFLUIDIC REACTORS AND PROCESS FOR THEIR PRODUCTION**

(30) Priority: 30.06.2017 GR 20170100305
(71) Applicant: NATIONAL CENTER FOR SCIENTIFIC RESEARCH "DEMOKRITOS", 15341 Agia Paraskevi Attikis (GR); Tserepi, Angeliki, 15341 Agia Paraskevi Attikis (GR); Chatzandroulis, Stavros, 15341 Agia Paraskevi Attikis (GR)
(72) Inventor: Tserepi, Angeliki, 15341 Agia Paraskevi Attikis (GR); Chatzandroulis, Stavros, 15341 Agia Paraskevi Attikis (GR); Kaprou, Georgia, 15341 Agia Paraskevi Attikis (GR); Kokkoris, Georgios, 15341 Agia Paraskevi Attikis (GR); Ellinas, Kosmas, 15341 Agia Paraskevi Attikis (GR); Papageorgiou, Dimitrios, 15341 Agia Paraskevi Attikis (GR)

(57) **Abstract**

Microfluidic reactors comprising at least one channel and/or at least one chamber on printed circuit boards or on a flexible printed circuit sheet which are sealed by a polyimide sealing film comprising on its sealing surface a B-staged acrylic adhesive. Process for the manufacture of such microfluidic reactors and their uses.

## Description

### Field of the Invention

The present invention relates to the field of microfluidics and lab-on-a-chip (LOC) fabrication. More specifically, it relates to enclosed microfluidic reactors on a printed circuit board (PCB) or on a flexible printed circuit sheet (FPC).

### Background of the invention

Microfluidics is the field of science and technology related to the manipulation and treatment of small (in the range of micro/nanoliters) amounts of fluids, employing microfluidic networks with minimum dimension in the range of tens to hundreds of micrometres (µm). Typical advantages of microfluidic systems include the possibility to use very small quantities of expensive reagents and scarce samples, to perform high resolution, precise and sensitive detection, to reduce the analysis time, cost and footprint for the analytical microdevices [Whitesides; Nature; 2006; 368-373; 442].

The interest in microfluidic devices has been continuously growing for the last two decades. Miniaturization of conventional laboratory processes in microfluidic platforms using well-established microfabrication technology has drawn great attention, and led to the development of the so-called LOC devices or systems. LOC aims at integration, miniaturization, parallelization, and automation of biochemical processes, performed into a small chip of a few square millimeters to a few square centimeters in size [Erickson and Li; Analytica Chimica Acta; 2004; 11-26; 507].

The combined benefits of ease of fabrication, low cost, and wide variety of material properties render polymers the material of choice when it comes to the fabrication of microfluidic devices as stand-alone devices or parts of lab-on-chip platforms. Polymers such as Polydimethylsiloxane (PDMS) [McDonald, et al., Acc. Chem. Res.; 2002; 491-499; 35], Polyurethane (PU) [Marshall, et al.; Analytical chemistry; 2012; 9640-9645; 84], Polymethyl methacrylate (PMMA) [Hong, et al.; Microfluidics and nanofluidics; 2010; 1125-1133; 9], cyclic olefin copolymer (COC) [Marshall, et al.; Journal of Chromatography A; 2014; 139-142; 1331], cyclic olefin polymer (COP) [Abad, et al.; ELECTROPHORESIS; 2012; 3187-3194; 33], Polyethylene (PE) [Khademhosseini, et al.; Lab on a Chip; 2004; 425-430; 4], and SU-8, a commonly used epoxy-based negative photoresist [Lin, et al.; Journal of Micromechanics and Microengineering; 2002; 590; 12], have been extensively implemented for the fabrication of microfluidics and LOC devices.

Recently, there is an increasing interest in using printed circuit boards (PCB) as (rigid or flexible) substrates for the development of microfluidic devices [Merkel, et al.; Sensors and Actuators, A: Physical; 1999; 98-105; 77, Gaßmann, et al.; Sensors and Actuators, A: Physical; 2007; 231-235; 133, C. Aracil et al.; Microelectronic Engineering; 2015; 13-18; 131]. The well-established PCB technology, industrially available for the mass production of electronic circuits and consumer electronics, as well as the low cost of the substrates makes it highly appealing. Moreover, the integration possibilities for electronics, microfluidics, sensors and actuators offered by the use of PCB are enormous. PCBs are typically composed of interchanging planar insulating layers of laminates -such as the flame retardant laminate sheet (FR4) which is fiberglass interwoven with an epoxy resin- and layers of conducting metal. The most commonly used metal is copper that may be present in many layers, also of different thickness.

Various implementations of PCB technology to microfluidic applications have been proposed in the literature for the formation of microfluidic patterns and their sealing, for creating enclosed microchannels and microchambers. Most of these implementations demand PCB process flow modification, and some type of pre/post-processing to realize an enclosed microfluidic system. Below, a description of the current state-of-the-art on microfluidics/LOC fabrication and sealing based on PCB technology follows.

Very early work on microfluidics fabrication using PCB technology proposed the use of copper as a material for the formation of microfluidic networks. By using lithography followed by etching of the outer copper layer, 3-sided channels (copper on sidewalls, FR4 on bottom) were patterned [Merkel, et al.; Sensors and Actuators, A: Physical; 1999; 98-105; 77] [Nguyen and Huang; Sensors and Actuators A: Physical; 2001; 104-111; 88], followed by sealing of the channel with a planar cover board (i.e. made of glass using epoxy resin to form fully enclosed microchannels. Another means of sealing microchannels patterned on copper (by lithography and wet etching) was based on spincoating of a UV-curable adhesive that bonds to a cover glass to create enclosed microchannels [Li, et al.; Lab on a Chip - Miniaturisation for Chemistry and Biology; 2014; 860-864; 14]. In addition, etching of an outer copper layer to form the microchannels (copper on sidewalls, FR4 on bottom) was used on two PCBs, which after alignment and lamination (with epoxy resin) form a fully enclosed microfluidic network [Gaßmann, et al.; Sensors and Actuators, A: Physical; 2007; 231-235; 133, Wego, et al.; Journal of Micromechanics and Microengineering; 2001; 528-531; 11]. This technique can be repeated as many times as necessary for an arbitrary number of layers on which the microfluidic network extends.

Fabrication of microfluidic channels has been also reported on flexible metalized polyimide (PI) films (referred to as flexible printed circuits, FPC, also implemented currently in the PCB industry), and specifically on both, a photosensitive type (e.g. PI2732, DuPont), which can be patterned by means of lithography, and a non-photosensitive type (e.g. PI2611, DuPont), which can be patterned by dry etching techniques. The sealing process that was followed uses n-methyl-2-pyrrolidone solvent (NMP is a swelling agent) in order to treat and swell the surface of partly imidized polyimide and allow higher interdiffusion with the polyimide cover layer [Metz, Holzer and Renaud; Lab on a Chip - Minituarization for Chemistry and Biology; 2001; 29-34; 1]. A non-photosensitive type of polyimide, Pyralux™, was microstructured by means of plasma etching (O₂/SF₆) and the device was sealed using a polyolefin cover with a pressure sensitive poly (dimethyl) siloxane (PDMS) adhesive [Mavraki, et al.; Procedia Engineering; 2011; 1245-1248; 25]. Similarly, another device was fabricated using the same patterning method and materials, but the sealing was performed using a commercially available Kapton® PI tape with a silicon adhesive [Moschou, et al.; Sensors and Actuators B: Chemical; 2014; 470-478; 199].

Furthermore, an extensively used epoxy resist, SU-8, has been used to form microchannels/microchambers on top of PCB. On the PCB, the electrical components were fabricated and then the PCB was coated with an SU-8 layer to aid the adherence of the fluidics which were patterned on a subsequent layer of SU-8 [Aracil, et al.; Microelectronic Engineering; 2015; 13-18; 131]. After the UV treatment, bake and development of the SU-8, the device was sealed with a thicker layer of SU-8 by means of BETTS (Bonding, UV-Exposure and Transferring Technique in SU-8) process [Aracil, et al.; Journal of Micromechanics and Microengineering; 2010; 035008; 20]. The described device served mixing purposes. In another case, the electrical components were formed on PCB by Cu etching. Then with the aid of an SU-8 layer, the surface of the PCB was planarized and resistors (Pt) were fabricated by Pt sputtering followed by lift off process. The microfluidics were then patterned on a second layer of SU-8. Afterwards, a thin layer of PMMA was spin-coated on the surface of the SU-8 channels. Finally, the device was sealed with a thicker plate of PMMA by thermal bonding with a thermal press [Kontakis, et al.; Microelectronic Engineering; 2009; 1382-1384; 86].

Very recently, dry film photosensitive resists (DFR) such as TMMF or 1002F have been used for planarization, encapsulation and creation of the microfluidic network and sealing on PCB substrates. More specifically, TMMR S2000 also called TMMF S2000 when sold as a dry resist from Tokyo Ohka Kogyo Co., Ltd [Wangler, et al.; Journal of Micromechanics and Microengineering; 2011; 21] was used to create the fluidics on a PCB surface. The patterning of the fluidics was achieved by UV exposure, development and baking at certain conditions. The channels were finally sealed with a second layer of TMMF which was also exposed and cured for 1 day [Palacios-Aguilera, et al.; International Conference on Quantum Nano and Micro Technologies (ICQNM); 2011; 71-76]. The 1002F polymer has been used to planarize and encapsulate surface mounted components on top of a PCB surface by casting the 1002F polymer and using a hot press and UV exposure. A second layer of 1002F was used for the fluidic patterning. Similarly, a hot press was used to make a planar layer of the 1002F polymer and after UV lithography the fluidics were patterned. The sealing of the device was achieved with a lamination process at 110°C using a tape or thin layer of cured 1002F polymer [Wu, et al.; Proceedings - Electronic Components and Technology Conference; 2011; 1576-1581, Wu, et al.; 15th International Conference on Miniaturized Systems for Chemistry and Life Sciences 2011, MicroTAS 2011; 2011; 1819-1821; 3].

To facilitate low cost and mass production of microfluidic devices, researchers have proposed materials with which PCB manufacturers are mostly familiar, such as the polyimide-based laminated dry film resists that have been implemented recently as patterning layers on top of commercial PCBs. For example, micromixers of various geometries were fabricated, after sealing them with thin polyolefin films [Papadopoulos, et al.; Microelectronic Engineering; 2014; 42-46; 124, Kefala, et al.; Microfluidics and Nanofluidics; 2015; 1047-1059; 19]. In addition, short microchannels on multilevel PCB stacks have been fabricated by standard PCB processing, however due to their small channel length, they do not develop high pressures during fluidic operation [Vasilakis, et al.; Applied Surface Science; 2016; 69-75; 368]. Furthermore, microfluidic devices for DNA amplification have been fabricated on PCB substrates by using either computer numerical control (CNC) machining or photolithography of laminated, dry-film, photosensitive PI, for the formation of meandering microfluidic channels. In the later work, copper facilitates the incorporation of on-chip resistive microheaters, defining the thermal zones necessary for isothermal or non-isothermal, polymerase chain reaction (PCR)-based, DNA amplification methods [Kaprou, et al.; Microsystem Technologies; 2016; 22:1529-1536], [Kaprou, et al.; Progress in Biomedical Optics and Imaging - Proceedings of SPIE; 2015; 9518]. Methods and materials for fabrication of PCB-based microfluidic devices for performing polymerase chain reaction (PCR) have been also described in US2013/0210080 A1, however the sealing process has not been described at all.

For the formation of microchannels and sealing purposes, in most of the previously mentioned works, with the exception of the work of Pagel and co-workers [Gabmann et al S & A: A 2007, Wego et al JMM 2001] where PCBs are glued one on top of the other, cover sheets and adhesive materials not commonly used in the PCB technology have been implemented (glass, PMMA, SU-8, TMMF, 1002F, polyolefin or silicone adhesives, etc.). Therefore, in most of these cases, the introduction of new materials and modified processes in the PCB industry would be required to allow upscaling of PCB-based microfluidics fabrication. Specifically, for sealing microfluidic channels/chambers/networks, even in the work of Pagel and co-workers, a *non-standard* PCB technology step has been proposed: an epoxy resin was to cover the PCBs, by means of dipping and withdrawing the boards from the resin solution, and letting them dry, thus using a complicated and time-consuming process. In other works [Mavraki et al. 2011, Proceedia Eng. 1245-1248, Moschou *et al.* 2014 470-478], materials based on PI such as Kapton® tapes or polyolefin tapes with a silicon pressure sensitive adhesive have been used, and they often led to sealed microfluidic devices of low robustness and fabrication throughput, especially when employed for applications where high temperatures are required for performing biological reactions.

However, sealing processes are very important in microfluidics fabrication, and indeed sealing of LOC devices is considered by experts as one of the important practical challenges [Temiz, et al.; Microelectronic Engineering; 2015; 156-175; 132] and an obstacle for the commercialization of microfluidics, since it has great impact on the manufacturing cost and the performance of the final devices. The microfluidics society (academia, research, industry) lacks suitable materials in order to seal inexpensively, easily, irreversibly, robustly, and massively, devices with long microchannels (where high pressures are expected to develop especially at high temperatures).

### Summary of the invention

The present invention provides a microfluidic reactor comprising at least one channel and/or at least one chamber on a printed circuit board or on a flexible printed circuit sheet sealed by a polyimide sealing film comprising an acrylic adhesive on its sealing surface. The present invention also provides a process for the manufacture of a microfluidic reactor comprising at least one channel and/or at least one chamber on a printed circuit board or on a flexible printed circuit sheet, wherein the process comprises the step of sealing the at least one channel and/or the at least one chamber of the printed circuit board or of the flexible printed circuit sheet with a polyimide sealing film comprising an acrylic adhesive on its sealing surface. The resulting microfluidic reactor is robust to temperatures up to at least 100° C and at this temperature it can handle pressure drops of at least up to 1.65 bar, thus it is suitable for performing (in it) biological reactions requiring elevated temperatures even in extremely long microchannels developing high pressure drop at high volumetric flow rates. At room temperature, the microfluidic reactor can handle pressure drops at least up to 8.3 bar.

The microfluidic reactors of the present invention can be used in a variety of ways, such as for performing amplification of DNA, based on polymerase chain reaction (PCR) or on isothermal DNA amplification protocols, as well as for performing thermal lysis of cells, requiring temperatures as high as 96-98° C. The present invention provides robust microfluidic reactors, which are manufactured in a cost efficient and easy manner, directly adaptable to the PCB industry.

### Brief description of the drawings

Figure 1 shows an image of three meander-like microfluidic chambers according to the present invention, fabricated onto PCB (above one resistive microheater).
Figure 2 shows the schematic of a continuous flow, closed-loop microreactor according to the present invention comprising 3 microchambers fabricated onto PCB (lying above 3 resistive microheaters).
Figure 3 shows the % sample volume in each microchamber with temperature within the accepted range (target temperature ±1.5 °C) as a function of the volumetric flow rate of the sample for a microfluidic reactor according to the present invention, designed for performing DNA amplification based on polymerase chain reaction.
Figure 4 shows an image of a continuous flow, closed-loop microreactor according to the present invention comprising meandering microchannels (lying above 3 resistive microheaters) fabricated onto PCB.
Figure 5 shows the design of a continuous flow meandering microfluidic channel (lying above 3 resistive microheaters) to be fabricated onto PCB by means of CNC micromilling or by means of photolithography, sealed according to the invention, and designed for performing DNA amplification based on polymerase chain reaction.
Figure 6 shows the design of a reactor, composed of a static chamber (lying above one resistive microheater) in series with a continuous flow microchannel (lying above 3 resistive microheaters), to be fabricated onto PCB, sealed according to the invention, and designed for performing cell lysis followed by DNA amplification based on polymerase chain reaction.

### Detailed description of the invention

The present invention provides a microfluidic reactor comprising at least one channel and/or at least one chamber on a printed circuit board or on a flexible printed circuit sheet sealed by a polyimide sealing film comprising a B-staged acrylic adhesive on its sealing surface.

Printed circuit boards (PCB) are typically composed of planar insulating layers such as an FR4 core (fiberglass interwoven with an epoxy resin), and layers of conducting metal, copper most commonly, on one or both sides of the insulating core layer. Flexible printed circuit (FPC) sheets typically consist of a thin insulating polymer film such as polyimide (PI), polyether ether ketone (PEEK), or polyester, and layers of conducting metal, copper most commonly, affixed on one or both sides of the thin insulating polymer film.

Polyimides are polymers of imide monomers and they include, depending on the polymers chain and the presence of other functional groups, linear 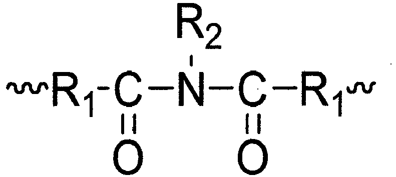 or cyclic (aromatic or aromatic-aliphatic) polyimides, with the following structure, respectively:

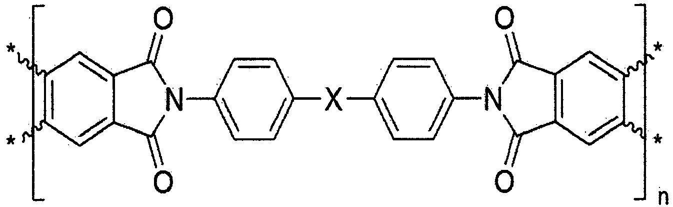

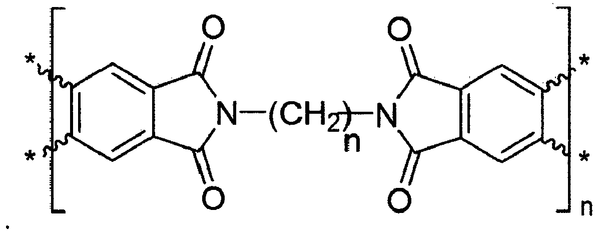

Preferably, according to the present invention the polyimide is an aromatic polyimide. More preferably, the polyimide is poly (4,4'-oxydiphenylene-pyromellitimide) which has the structure of formula (I):

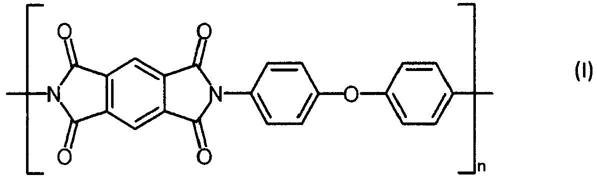

An example of a poly (4,4'-oxydiphenylene-pyromellitimide) film coated on one side with a B-staged acrylic adhesive is the DuPont™ Pyralux® LF coverlay, that is routinely used by the PCB/FPC industry to encapsulate etched metallic details in flexible and rigid-flex multilayer constructions for environmental and electrical insulation.

The sealing film may also be a single-sided metal-clad polyimide laminate. Such laminates comprise aromatic polyimide layers and a metal foil on one side. When they are used as sealing films according to the present invention, the metal foil covers the surface of the film, which is opposite to the sealing surface. Various metals such as copper, aluminum, and gold may be used in such metal-clad polyimide laminates for flex circuitry applications (insulation, passivation, etc.) and are commercially available. The acrylic adhesive according to the present invention is an adhesive comprising reactive acrylic precursors, such as methacrylic acid and methyl methacrylate, and a free radical initiator system, such as organic peroxides (R-O-O-R') or azo compounds (R-N=N-R'). The term "B-staged adhesive" designates an adhesive in which the majority of the solvent has been removed and the precursors have been partially polymerized to allow easy handling of the sealing film until final curing (polymerization) during exposure of the stack (sealing film and substrate) to necessary conditions (heat and pressure, in this invention).

The sealing surface according to the present invention is the surface of the sealing film which faces the at least one channel/chamber of the printed circuit board or of the flexible printed circuit sheet.

According to a preferred embodiment, the microreactor comprises a microheater. The microheater may be of any suitable type, such as a resistive microheater or an induction microheater. The microheater is typically integrated on the same PCB/FPC substrate on which the microchamber/channel is formed.

The present invention also provides a process for the manufacture of a microfluidic reactor comprising at least one channel and/or at least one chamber on a printed circuit board or a flexible printed circuit sheet, wherein the process comprises the step of sealing the at least one channel and/or the at least one chamber of the printed circuit board or of the flexible circuit sheet with a polyimide sealing film, comprising a B-staged acrylic adhesive on its sealing surface.

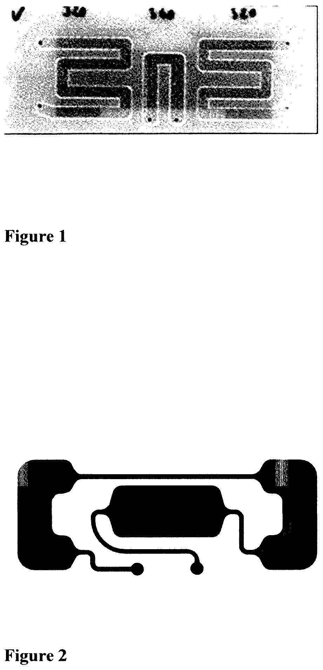

The microfluidic network may be patterned on PCB using either computer numerical control (CNC) machining to create engraved networks or employing a photoimageable dry film (dry film resist) routinely used in the PCB/FPC industry, such as the DuPont™ Pyralux® PC 1000. The photoimageable dry film, DuPont™ Pyralux® PC 1000, consists of a specially developed combination of acrylic, urethane, and imide-based material and its proposed use (from the manufacturer) is the encapsulation of flexible printed circuitry (mainly used as solder mask). To use the materials described in this invention as a sealing film for microfluidic channels or chambers, a hot press operating at elevated temperature, and simultaneously at high pressure, is required. First, the sealing material is laminated on the patterned PCB/FPC. Subsequently, the laminated PCB/ or FPC/adhesive/PI stack is put on a press, when the desired temperature is reached, preferably in the range of 182°C-193°C (for temperatures lower than 180°C the sealing layer may not seal effectively the microchannels, while for temperatures higher than 193°C the microchannels may be clogged). Then a pressure is set, preferably in the range of 450-750 psi, for a duration of typically 20-30 minutes. At this high pressure range, to avoid collapsing of the sealing film over large microchambers (as those in Figs. 1 and 2), a stencil bearing identical patterns (through microchambers/channels) as those on the PCB/FPC (to be sealed) may be placed just above the PCB/ or FPC/adhesive/ PI stack (on the side of PI) and pressed against the stack in a hot press. After typically 20-30 min, the heating is turned off and the press is left to cool down to around 100 °C before the pressure is dropped and the stack is withdrawn from the press. The best results in terms of the robustness of the sealing are obtained at a temperature of 189°C and a pressure of 450 psi, applied for 30 min, when sealing lithographically created microchannels on PCB. Preferably, according to the present invention the bonding strength of the sealing film is at least 8.3 bar at room temperature and at least 1.65 bar at 95°C, as measured on a tensile tester machine.

The sealing material of the present invention is preferred over other materials comprising pressure sensitive adhesives such as Kapton® PI and polyolefin tapes, both with silicone thermoset adhesive, due to its superior bonding strength. According to our experiments, when Kapton® 7270 (comprising a Kapton® tape with a silicone thermosetting adhesive) or Advanced Polyolefin StarSeal (self-adhesive) film (from STARLAB International GmbH) were implemented to seal meandering microchannels, the bonding strength was not enough to withstand the pressure drop developed during continuous flow of water in the microchannel at high temperatures. Specifically, when Kapton® 7270 was used as sealing film of a microfluidic reactor integrated with a microheater, it peeled-off in less than 5 minutes of operation, when the temperature of the microheaters reached 72°C, while water at a flow rate of 2 µl/min was flowing through the microchannel. When StarSeal advanced polyolefin film was implemented as sealing layer, it peeled-off in less than 5 minutes of operation, when the temperature reached 65°C with water flowing through the meandering microchannel at a flow rate of 2 µl/min.

Microdevices fabricated according to the present invention may be used reliably and reproducibly as microreactors for successfully performing in them biological reactions requiring high temperatures, such as thermal cell lysis (requiring temperatures up to 96-98 °C), as well as the polymerase chain reaction (requiring temperatures up to 95 °C) or isothermal amplification reactions. The advantages of the process described in the present invention include the implementation of materials and methods with which the PCB/FPC industry is very familiar, thus enhancing the potential for low-cost, mass production of such microdevices by the PCB/FPC industry. This process is especially suitable for the reliable and irreversible sealing of microdevices with extremely long microchannels (> 1.5 m) where high pressures are expected to develop during their operation.

### Examples

### Example 1:

### A) Fabrication of 3 sealed microfluidic chambers lying above a single microheater (Fig. 2)

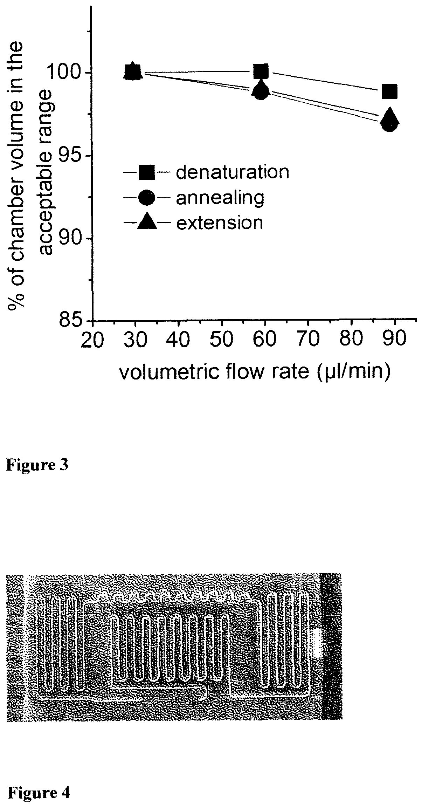

First, a resistive element (microheater) is designed according to desired specifications (i.e. resistance value, total dimensions of the device) and the design rules of the PCB manufacturer (i.e. dimensions of copper route, vias, etc.) and sent for fabrication to a PCB manufacturer. Then, the microfluidic chambers are designed according to desired specifications (i.e. sample volume, depth). After the PCB with the fabricated microheater is received from the PCB manufacturer, the microfluidic chambers are milled according to our specifications (i.e. depth) and the dimensions of the desired pattern. In this case, three chambers are milled (see Figure 1), each consisting of a 2 mm wide channel and of a total length of 5 cm (chambers on side) or 2.5 cm (chamber in the middle). Alternatively, photolithography is used on a dry film photoresist to form the microfluidic chambers. In detail, the dry film photoresist is laminated on PCB using a roll laminator. Then, the desired photolithographic mask is used through which the dry photoresist/PCB stack is exposed to UV radiation. Once the exposure is over, the resist/PCB stack is placed onto the hotplate for 1-2 minutes at 120°C (soft-bake). Development is performed using a 1% sodium carbonate aqueous solution. After development, the patterned PCBs are rinsed under distilled water and dried using pressurised nitrogen (nitrogen gun). Finally, they are placed in an oven for 2-3 hours at 160°C for the hard bake. Then through holes are drilled for the inlet and outlet of the chambers. The patterned PCB with the embedded microheater is cleaned as follows: First, acetone is used, then propanol and finally rinsed with distilled water. Afterwards, the PCB is dried using pressurized nitrogen (nitrogen gun) and further dried on a hot plate at 120°C for 15 minutes. Once the PCB is dried, it is removed from the hot plate and is left to cool down to room temperature. Next, an aromatic PI film coated on one side with a B-staged acrylic adhesive (DuPont™, Pyralux® LF coverlay) is laminated on the patterned PCB. Then, the laminated PCB/adhesive/aromatic PI film stack is put on a press brought at the desired temperature and a pressure is then applied. The pressure (on the stack) and elevated temperature are set, preferably in the range of 450-750 psi and 182°C-193°C, respectively, for 20-30 minutes. At this high pressure, to avoid collapsing of the sealing layer over large microchambers (as those in Fig. 3) or clogging of the microchannels with the adhesive material, a stencil bearing identical patterns (open microchambers/channels) as those on the PCB (to be sealed) is placed just above the PCB/adhesive/aromatic PI stack, pressed against each other in the press.

### B) Isothermal DNA amplification in the chambers

In the chambers fabricated according to the above, isothermal DNA amplification protocols were carried out, for example the Helicase Dependent Amplification (HDA) method. The HDA reactions were supplied with a set of primers (Forward: 5'-TGA TGG GTT GTG TTT GGT TTC TTT CAG-3' and Reverse: 5'-ACC TTT CTG TCC TGG GAT TCT CTT GCT-3') that produce a 113 bp fragment and a 157 bp PCR fragment containing the sequence of interest (Vorkas et al. 2010) used as template. 25 µl of an HDA isothermal amplification reaction prepared according to the manufacturer's instructions (Biohelix, IsoAmp® II Universal tHDA Kit) were loaded in the device and incubated for 15 min (BRCA1), with the microheater adjusted to provide 65 °C in the microchambers. Successful DNA amplification was demonstrated in such devices [Kaprou, et al.; Microsystem Technologies; 2016; 22:1529-1536]. In case that several chambers (three in the microdevice of Fig. 1) are fabricated lying on the heating zone, several reactions (requiring the same temperature protocol) can be performed simultaneously, thus increasing the throughput of the DNA amplification that can be performed in such microdevices.

### Example 2:

Design and fabrication of closed-loop microfluidic reactor composed of 3 chambers or meandering microfluidic channels (Fig. 2 and Fig. 4, respectively) for performing DNA amplification based on polymerase chain reaction (PCR) or isothermal protocols.

A specification for efficient PCR amplification is the temperature uniformity of the DNA sample (variation should be less than ±1.5 °C) at each one of the thermal zones. Therefore, simulations are necessary to find appropriate separation between the three microchambers (each of 5 ul volume and dimensions 0.8 cm x 1.3 cm), in each one of which one step of PCR is to be performed (one chamber for denaturation performed typically at 95 °C, a second for annealing typically at 55 °C, and a third for extension typically at 72 °C). With inlet velocity in the range 30-90 µ/min, appropriate for a reasonable total PCR duration (5 up to 15 min for 30 cycles), the temperature uniformity was examined across the three chambers for optimizing the distance between them and minimal power consumption. The temperature uniformity in a zone (e.g., denaturation zone) is quantified by the % percentage of the sample volume in the zone with fluid temperature within a range of ±1.5 °C from the set point. Figure 3 shows this percentage for the three zones versus the inlet velocity. With the inlet velocity in the range 30-90 µ/min, the temperature uniformity exceeds 95 % for all zones, with the denaturation exhibiting the highest uniformity. Then, the resistive elements are designed according to specifications (i.e. resistance value, total dimensions of the device) and the design rules of the PCB manufacturer (i.e. dimensions of copper route, vias etc.). After the PCB with the 3 microheaters is received from the PCB manufacturer, the microfluidic reactor is fabricated and sealed, as described in detail in Example 1 (A).

### Example 3:

### A) Fabrication of a continuous flow meandering microfluidic channel and performance of DNA amplification based on PCR

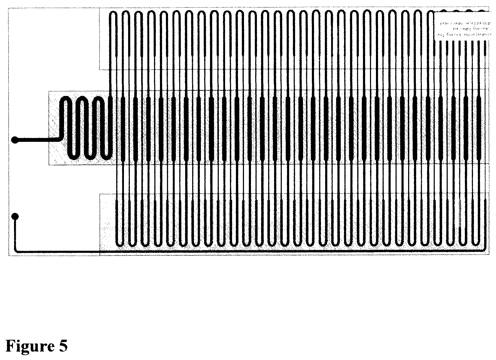

Based on the requirements for efficient PCR amplification, which are explained in Example 2 (temperature variation of the DNA sample should be less than ±1.5 °C at each thermal zone), a continuous flow microchannel (width 300/500 µm, total length of 180 cm) and the relative position of the 3 microheaters (defining three temperature zones necessary for PCR) were designed to ensure successful DNA amplification after 30 cycles, provided the DNA sample flows through such microchannel (see Figure 5). Then, the resistive elements were designed according to design requirements (in agreement with simulations), the specifications for the heaters (i.e. resistance value, total dimensions of the device) and the design rules of the PCB manufacturer (i.e. dimensions of copper route, vias etc.). The PCB substrates with the embedded microheaters are cleaned and dried as described in Example 1. The microfluidic device is patterned either by CNC machining creating microchannels of a minimum depth of 90 µm or by photolithography creating microchannels of a minimum depth of 50 µm, as also described in Example 1. After the completion of the patterning, through holes are drilled for the inlet and outlet of the microfluidic channel. The devices are rinsed with distilled water to remove any dirt and are dried with pressurised nitrogen. Finally, the microfluidic microchannel is sealed according to the sealing process described in detail in Example 1. A pressure drop of 8.3 bar is estimated when water flows through the microchannel with a flow rate of 100 µl/min. The fabricated microdevice was proven robust at least up to this high pressure.

### B) DNA amplification

The DNA amplification protocol performed is the Polymerase Chain Reaction (PCR) amplification method. PCR is a temperature-mediated enzyme catalysed DNA amplification reaction requiring 3 different temperatures (denaturation at around 95°C, annealing at around 55°C depending on the set of primers and extension at 72°C). In addition, as understood by a person skilled in the art, 2 different temperatures are also possible for a 2 temperature DNA amplification, where annealing and extension are performed at the same temperature (in such case, two microheaters instead of three are required). Plasmid DNA as well as a short fragment of human DNA were used to verify the DNA amplification efficiency of the device. pBR322 is a commonly used plasmid cloning vector in E. coli. The molecule is double-stranded circle, 4361bp in length. pBR322 contains the genes for resistance to ampicillin and tetracycline. To amplify 2 particular gene sequences, corresponding to resistance genes, the PCR reactions were supplied with 2 different sets of primers that produce a 200 bp fragment and a 400 bp. Approximately 25 µl of a PCR amplification reaction was prepared according to the manufacturer's instructions KAPA Taq HotStart PCR Kit. The flow rates used for these reactions ranged from 1 µl/min to 20 µl/min. Sufficient amplification of DNA was achieved within a few min (5 min for the short DNA fragment). The pressure drop corresponding to the highest flow rate implemented (20 µl/min) during the microdevice operation is estimated at 1.65 bar. However, the device was able to withstand much higher pressures at room temperature, where flow rates as high as 100 µ1/min were implemented (leading to a pressure drop of 8.3 bar across the device) without delaminating the cover layer.

### Example 4:

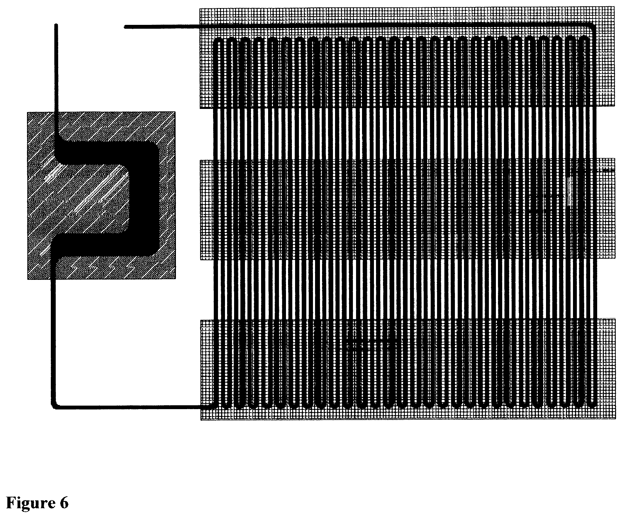

### Fabrication of a Lab-on-a-chip (LOC), composed of a static chamber combined with a continuous flow meandering microfluidic channel, and performance of cell lysis and DNA amplification based on PCR (Figure 6).

The microfluidic network (Figure 6) is composed of one static chamber as described in Example 1 and one continuous flow meandering microchannel as described in Example 3. Specifically, the static chamber consists of a 2 mm wide channel and 2.5 cm long, while the continuous flow microchannel consists of 28 cycles (instead of 30, as in Example 3). The outlet of the static chamber is connected to the inlet of the continuous flow microchannel. The static chamber lies above a resistive microheater, designed and fabricated as described in Example 1, while the meandering microchannel lies above three resistive microheaters, designed and fabricated as described in Example 3. The microfluidic network is fabricated on PCB either by means of CNC milling or photolithography using a dry film photoresist, as described in Example 1. Finally, the formed microfluidic network is sealed with the sealing film and the process described in detail in Example 1. A biological sample containing the target bacteria cells together with the PCR reagents is introduced in the static chamber and the chamber is heated by means of the integrated resistive microheater to a temperature in the range 93-98 °C to lyse the cells and release the target genomic DNA. Then, the static chamber is thermocycled using the same integrated microheater, so that two PCR cycles of the genomic DNA are performed in the same chamber. After completion of 2 PCR cycles, the DNA-containing sample is introduced into the meandering microchannel where the DNA is amplified, as it flows through the meandering microchannel. This microreactor (composed of a static chamber combined with a continuous flow microchannel) combines the advantage of a static chamber with respect to its capability to efficiently perform the first two PCR cycles for the amplification of genomic DNA, with the advantage of a continuous flow microchannel with respect to its capability to rapidly amplify DNA. It is also a representative example of a Lab-on-a-chip (LOC) where various biochemical processes, such as cell lysis and DNA amplification (in this case) are integrated and performed on the same device.

## Claims

1. A microfluidic reactor comprising at least one channel and/or at least one chamber on a printed circuit board or on a flexible printed circuit sheet, sealed by a polyimide sealing film comprising a B-staged acrylic adhesive on its sealing surface.

2. A microfluidic reactor according to claim 1, wherein the polyimide is an aromatic polyimide.

3. A microfluidic reactor according to claim 1 or 2, wherein the polyimide is poly (4,4'-oxydiphenylene-pyromellitimide).

4. A microfluidic reactor according to claim 1, wherein the sealing film is a single-sided metal-clad polyimide laminate.

5. A microfluidic reactor according to claim 4, wherein the metal is selected from the group consisting of copper, aluminum, and gold.

6. A microfluidic reactor according to any one of claims 1 to 5, wherein the bonding strength of the sealing film measured by tensile testing is at least 8.3 bar at room temperature and at least 1.65 bar at 95°C.

7. A microfluidic reactor according to any one of claims 1 to 6, wherein the reactor further comprises a microheater.

8. A microfluidic reactor according to claim 7, wherein the microheater is a resistive microheater.

9. A process for the manufacture of a microfluidic reactor according to any one of claims 1 to 8, wherein the process comprises the step of sealing the channels and/or chambers of the printed circuit board or of the flexible printed circuit sheet with a polyimide sealing film comprising a B-staged acrylic adhesive on its sealing surface.

10. A process according to claim 9, wherein the sealing is performed at a temperature of 182°C-193°C.

11. A process according to any one of claim 9 or 10, wherein the sealing is performed at a pressure of 450-750 psi.

12. A process according to any one of claims 9 to 11, wherein the sealing is performed for 20-30 minutes.

13. A process according to any one of claims 9 to 12, wherein the sealing is carried out in the presence of a stencil which bears identical patterns as those on the printed circuit board or on the flexible printed circuit sheet and is placed on top of the non-sealing surface of the sealing film.

14. Use of a microfluidic reactor according to any one of claims 1 to 8, for performing amplification of DNA or thermal lysis of cells.

15. Use of a microfluidic reactor according to any one of claims 1 to 8, for performing a series of biochemical processes.
